Europäisches Patentamt

European Patent Office

Office européen des brevets

(11) Veröffentlichungsnummer: **0 465 862 A2**

# EUROPÄISCHE PATENTANMELDUNG

(21) Anmeldenummer: **91109699.8**

(22) Anmeldetag: **13.06.91**

(51) Int. Cl.5: **H01L 21/338**, H01L 29/812

(30) Priorität: **15.06.90 DE 4019231**

(43) Veröffentlichungstag der Anmeldung:
**15.01.92 Patentblatt 92/03**

(84) Benannte Vertragsstaaten:
**BE FR GB IT NL SE**

(71) Anmelder: **FORSCHUNGSZENTRUM JÜLICH GMBH**
**Wilhelm-Johnen-Strasse**
**W-5170 Jülich(DE)**

(72) Erfinder: **Schüppen, Andreas**
**Robert-Koch-Strasse 7**
**W-5170 Jülich(DE)**
Erfinder: **Lüth, Hans, Prof. Dr.**
**Eupener Strasse 299b**
**W-5100 Aachen(DE)**

(54) Transistor mit permeabler Basis und Verfahren zu dessen Herstellung.

(57) Die Erfindung bezieht sich auf ein Verfahren zur Herstellung eines elektronischen Bauelementes mit n- und $n^+$-dotierter oder p- und $p^+$-dotierter Schicht aus halbleitendem Material und einer Schicht aus leitfähigem Material, die streifengitterförmig strukturiert ist. Aufgabe der Erfindung ist es, ein Verfahren zur Herstellung eines solchen elektronischen Bauelementes zu schaffen, dessen Kapazität gegenüber herkömmlichen Bauelementen vermindert ist. Hierzu wird zunächst ein Schichtsystem gebildet, das aus einer Schicht aus Isolatormaterial, darauf aufgebrachter Schicht aus leitfähigem Material und darauf aufgebrachter weiterer Schicht aus Isolatormaterial besteht. Dieses Schichtsystem wird anschließend streifengitterförmig strukturiert und die dabei entstehenden Zwischenräume des streifengitterförmigen Schichtsystems durch selektives Wachstum mit Halbleitermaterial gefüllt. Die Erfindung bezieht sich ferner auf ein elektronisches Bauelement der bezeichneten Art, das das streifengitterförmig strukturierte Schichtsystem aus aufeinanderfolgenden Schichten aus Isolatormaterial, leitfähigem Material und Isolatormaterial aufweist und bei dem die Zwischenräume des streifengitterförmigen Schichtsystems mit halbleitendem Material ausgefüllt sind.

FIG. 2

Die Erfindung bezieht sich auf ein Verfahren zur Herstellung eines elektronischen Bauelementes mit n- und $n^+$-dotierter oder p- und $p^+$-dotierter Schicht aus halbleitendem Material und einer Schicht aus leitfähigem Material, die streifengitterförmig strukturiert ist. Die Erfindung bezieht sich ferner auf ein solches elektronisches Bauelement.

Es ist das Bestreben der Fachwelt, Bauelemente der eingangs bezeichneten Art für höhere Transitfrequenzen zu entwickeln, als dies bisher möglich ist. Wie aus C.O. Bozler, G.D. Alley: "Fabrication and numerical simulation of the Permeable Base Transistor", IEEE Trans.Elec.Dev. ED-27, No 6 1980, pp.1128-1141 hervorgeht, ergaben Simulationsrechnungen, daß Transitfrequenzen von über 200 GHz mit Permeable Base Transistors (PBTs) möglich sind, deren Kanal- und Gitterbreiten (die Breite eines auch als Gatefinger bezeichneten Gitters und die Kanalbreiten, d.h. die Abstände zwischen zwei Gatefinger) unter 100 nm liegen. Um diese Transitfrequenzen in der Praxis zu erreichen, müßte die Kapazität des Bauelements gesenkt und/oder dessen Steilheit erhöht werden. Dabei ist zu beachten, daß die Raumladungszonen um die Gitter (Gatefinger) die gesamte Kapazität des intrinsischen Transistors bilden.

Es ist Aufgabe der Erfindung, ein Verfahren zur Herstellung eines elektronischen Bauelementes der eingangs bezeichneten Art bzw. ein solches Bauelement zu schaffen, dessen Kapazität gegenüber Bauelementen der bekannten Bauart vermindert ist.

Diese Aufgabe wird bei einem Verfahren der bezeichneten Art erfindungsgemäß dadurch gelöst, daß zunächst ein Schichtsystem gebildet wird, das aus einer Schicht aus Isolatormaterial, darauf aufgebrachter Schicht aus leitfähigem Material und darauf aufgebrachter weiterer Schicht aus Isolatormaterial besteht, daß dieses Schichtensystem streifengitterförmig strukturiert wird und danach die Zwischenräume des streifengitterförmigen Schichtsystems mit Halbleitermaterial durch selektives Wachstum gefüllt werden. Dabei wird (gemäß Anspruch 2) zweckmäßigerweise so vorgegangen, daß zunächst eine unterste Schicht aus niederohmigem Halbleitermaterial gebildet wird und darauf das Schichtsystem durch nacheinanderfolgendes Aufbringen der einzelnen Schichten aus Isolatormaterial und leitfähigem Material aufgebracht werden.

Nach geeigneter Dotierung des Halbleiters und Aufbringen der Metallschichten für den Quell-(Source-) und den Senke-(Drain)kontakt erhält man die gewünschte PBT-Struktur.

Die Herstellung des Bauelementes ist sowohl mit Silizium als auch mit III/V Halbleitermaterialien möglich, wobei das Auftragen der Schichten mittels LPVPE (Low Pressure vapour phase epitaxy bzw. Niederdruck Gasphasenepitaxy) oder MOCVD (Metallorganische Chemische Gasphasen Deposition) erfolgen kann. Die Strukturierung des aus dem Isolatormaterial und dem leitfähigen Material gebildeten Schichtsystems wird zweckmäßigerweise durch reaktives Ionenätzen vorgenommen.

Als Isolatormaterial bieten sich $SiO_2$ oder $Si_3N_4$ an, als leitfähiges Material ist bekanntermaßen jedes Material einsetzbar, das mit dem halbleitendem Material eine Schottky-Bariere ausbildet. Als solches sind Platin, Wolfram und $CoSi_2$ zu nennen.

Nach dem erfindungsgemäßen Verfahren ist ein Bauelement herstellbar, bei dem durch die niedrigere Dielektrizitätskonstante der Isolatorschicht die Raumladungkapazitäten oberhalb und unterhalb der Gatefinger verringert werden, so daß höhere Transitfrequenzen resultieren. Auch kann durch größere Dicken der Isolatorschicht eine Erhöhung der Transitfrequenz erzielt werden, ohne daß eine Verkleinerung der lateralen Abmessungen der Gatefinger vorgesehen werden muß. Dabei sollten die Dicken der Isolatorschichten größer sein als die Weiten der Raumladungszonen, die sich in Halbleitermaterial oberhalb und unterhalb des Streifengitters ausbilden würden. Beispielsweise sind für Streifengitterbreiten (Gatefingerbreiten) von 0,5 mm Isolatorschichtdicken von 250 - 400 nm und für Streifengitterbreiten von 0,1 $\mu$m Isolatorschichtdicken von 100 - 200 nm zu wählen.

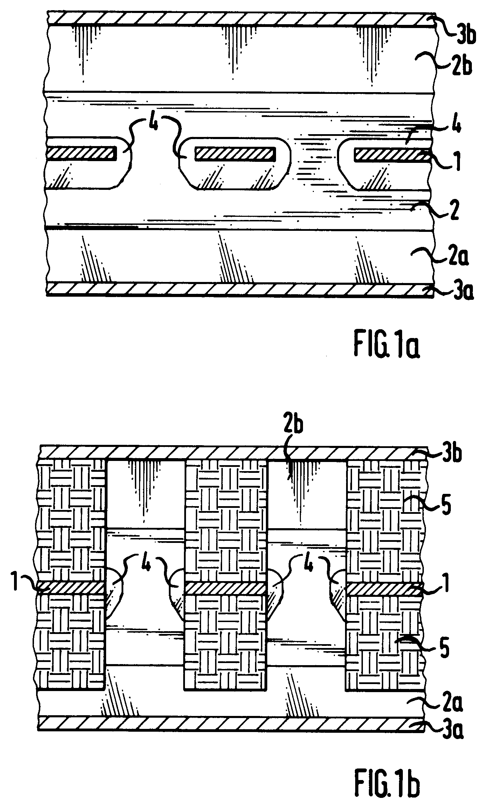

Die Dicke des Metalls bzw. Silizids der leitfähigen Schicht kann mittels standardmäßigen Metallisierungsverfahren fast beliebig eingestellt werden und ist genau bestimmbar. Das recht komplizierte epitaktische Aufwachsen der Silizid- bzw. Metallschicht, wie es bei einem Bauelement bekannter Bauart (s. Figur 1a) erforderlich ist, entfällt dagegen beim Verfahren gemäß der Erfindung.

Die Aufgabe gemäß der Erfindung wird somit durch ein elektronisches Bauelement gelöst, daß die kennzeichnenden Merkmale des Anspruchs 7 aufweist. Das aus den drei Schichten aus Isolatormaterial, leitfähigem Material und Isolatormaterial bestehende Schichtsystem kann dabei auf einer durchgehenden Schicht aus niederohmigen Halbleitermaterial aufgebracht sein.

Eine besonders vorteilhafte Variante des Bauelements gemäß der Erfindung besteht in der Ausführungsform mit den Merkmalen des Anspruchs 9. Dotiert man bei solchen Bauelementen mit mehreren Schichten aus leitfähigem Material und darauf folgender Schicht aus Isolatormaterial das Halbleitermaterial abwechseln $n^-$ und $n^+$ oder p- und $p^+$, so erhält man ein Bauelement, das aus mehreren Übereinander angeordneten Transistoren besteht. Diese können bei geeigneter lateraler und vertikaler Verkoppelung dreidimensional integriert werden.

Die verschiedenen Ausführungsformen des Bauelements gemäß der Erfindung weisen zweckmäßigerweise eine Isolatorschichtdicke gemäß Anspruch 10 auf.

In der Zeichnung sind Ausführungsbeispiele des Bauelements gemäß der Erfindung schematisch dargestellt und werden im folgenden näher erläutert:

Es zeigen

Figur 1a ein elektronisches Bauelement bekannter Bauweise

Figur 1b ein elektronisches Bauelement mit Isolatorschicht und demgemäß verringerter Raumladungszone

Figur 2 ein elektronisches Bauelement mit mehreren Schichten aus leitfähigem Material und jeweils darauffolgender Schicht aus Isolatormaterial

Beim Bauelement bekannter Bauweise ist das streifenförmige Gitter 1 (Gatefinger 1, bzw. Basis) von halbleitendem Material 2 ganz umgeben. An das nicht dotierte Halbleitermaterial schließen sich die dotierten Zonen 2a und 2b und an diese die Metallschichten 3a bzw 3b an. Diese bilden die Quelle 3b (source, bzw. emitter) und die Senke 3a (drain, bzw. collector).

Die Raumladungszonen (im Halbleitermaterial) 4 bilden sich bei der bekannten Ausführungsform des Bauelementes - wie aus Figur 1a ersichtlich ist - rund um die Gatefinger 1 aus.

Demgegenüber bilden sich bei dem in Figur 1b dargestellten Bauelement gemäß der Erfindung Raumladungszonen 4 im wesentlichen nur seitlich der Gatefinger 1 aus , da sich unterhalb und oberhalb der Gatefinger 1 Isolatorschichten 5 anschließen, deren Dicken größer sind als die Raumladungszonen 4 im Halbleitermaterial oberhalb und unterhalb der Gatefinger 1 im entsprechenden, in Fig. 1a dargestellten, bekannten Bauelement

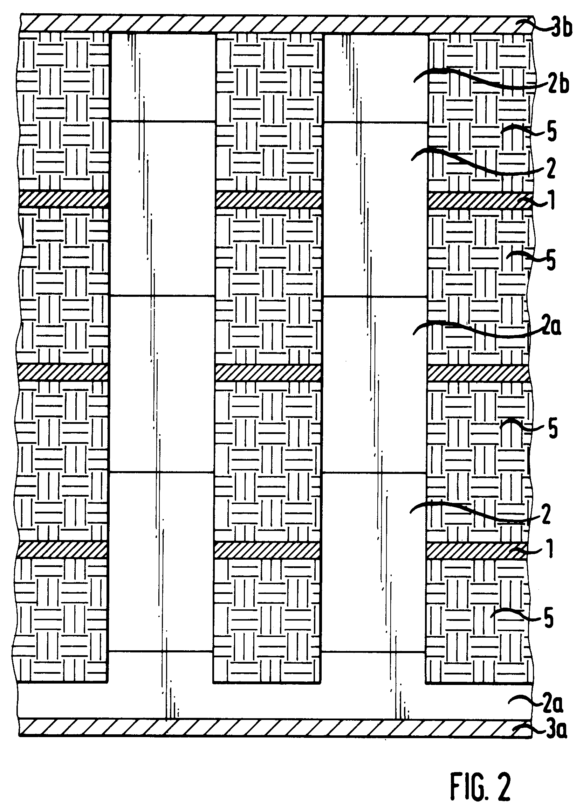

Das in Figur 2 dargestellte Bauelement weist mehrere streifenförmige Gitter 1 und dementsprechend mehrere Isolatorschichten 5 auf. Das Halbleitermaterial ist abwechselnd $n^-$ und $n^+$ oder $p^-$ und $p^+$ dotiert, wodurch drei Transistoren übereinander angeordnet sind.

Für einen Transistor der in Figur 1b dargestellten Art wurde der Gewinnfaktors G in der Transitfrequenz gegenüber dem in Figur 1a dargestellten Transistor ermittelt:

Bei gewissen Annahmen (für die Raumladungszonen oberhalb und unterhalb der Gatefinger wurde das Plattenkondensatormodell angenommen, die Kapazitäten aus den Raumladungszonen rechts und links der Gatefinger werden als Halbzylinderkondensatoren beschrieben) wurden zwei Beispiele mit den nachfolgenden Abmessungen der Rechnung zugrundegelegt:

Beispiel 1

Dicke des Gatematerials (Gatelänge): 20nm
Weite der Raumladungszone oberhalb des Gates (zum source): 100nm
Weite der Raumladungszone unterhalb des Gates (zum drain): 300nm
relative Dielektrizitätskonstante des Halbleiters: 11.9
relative Dielektrizitätskonstante des Isolators: 3.9
Breite des Gatemetalls eines Fingers: 1 $\mu$m
Kanalbreite, Abstand zwischen zwei Gatefingern: 1 $\mu$m
Dicke des Isolatormaterials: 500nm
Der Gewinnfaktor errechnet sich zu 3.97.

Beispiel 2

Dicke des Gatemetalls (Gatelänge): 10nm
Weite der Raumladungszone oberhalb des Gates (zum source): 50nm
Weite der Raumladungszone unterhab des Gates (zum drain): 150nm
relative Dielektrizitätskonstante des Halbleiters: 11.9
relative Dielektrizitätskonstante des Isolators: 3.9
Breite des Gatemetalls eines Fingers: 100nm
Kanalbreite, Abstand zwischen zwei Gatefingern: 100 nm
Dicke des Isolatormaterials: 200nm
Der Gewinnfaktor aus G errechnet sich zu 1.76.

**Patentansprüche**

1. Verfahren zur Herstellung eines elektronischen Bauelements mit n- und $n^+$-dotierter oder p- und $p^+$-dotierter Schicht aus halbleitendem Material und einer Schicht aus leitfähigem Material, die streifengitterförmig strukturiert ist, **dadurch gekennzeichnet,** daß zunächst ein Schichtsystem gebildet wird, das aus einer Schicht (5) aus Isolatormaterial, darauf aufgebrachter Schicht (1) aus leitfähigem Material und darauf aufgebrachter weiterer Schicht (5) aus Isolatormaterial besteht, daß dieses Schichtsystem streifengitterförmig strukturiert wird und danach die Zwischenräume des streifengitterförmigen Schichtsystems mit Halbleitermaterial durch selektives Wachstum (2) gefüllt werden.

2. Verfahren nach Anspruch 1, **dadurch gekennzeichnet,** daß das streifengitterförmige Schichtsystem auf einer Schicht (2a) aus halbleitendem Substrat gebildet wird.

3. Verfahren nach Anspruch 1 oder 2, **dadurch gekennzeichnet,** daß das aus dem Isolatormaterial und dem leitfähigen Material gebildete Schichtsystem durch reaktives Ionenätzen strukturiert wird.

**4.** Verfahren nach einem der vorhergehenden Ansprüche,
**dadurch gekennzeichnet,**
daß als Isolatormaterial $SiO_2$ oder $Si_3N_4$ vorgesehen ist.

**5.** Verfahren nach einem der vorhergehenden Ansprüche,
**dadurch gekennzeichnet,**
daß als leitfähiges Material Platin, Wolfram oder $CoSi_2$ vorgesehen ist.

**6.** Verfahren nach einem der vorhergehenden Ansprüche,
**dadurch gekennzeichnet,**
daß auf das aus der Schicht (5) aus Isolatormaterial, der Schicht (1) aus leitfähigem Material, der weiteren Schicht (5) aus Isolatormaterial bestehende Schichtsystem mindestens ein weiteres Paar von Schichten aufgetragen wird, das aus einer Schicht (1') aus leitfähigem Material und einer weiteren Isolatorschicht (5') besteht, daß danach das gesamte Schichtpaket streifengitterförmige strukturiert wird und anschließend die Zwischenräume des Streifengitters mit Halbleitermaterial durch selektives Wachstum gefüllt werden.

**7.** Elektronisches Bauelement mit Schichten aus n-und $n^+$-dotierten oder p- und $p^+$-dotierter Schichten aus Halbleitermaterial und einer streifengitterförmig strukturierten Schicht aus leitfähigem Material,
**gekennzeichnet durch**
ein streifengitterförmig strukturiertes Schichtsystem aus aufeinanderfolgenden Schichten (5,1,5) aus Isolatormaterial, leitfähigem Material und Isolatormaterial, dessen Zwischenräume mit halbleitendem Material ausgefüllt sind.

**8.** Elektronisches Bauelement nach Anspruch 7,
**dadurch gekennzeichnet,**
daß das aus Isolatormaterial, leitfähigem Material und Isolatormaterial bestehende Schichtsystem (5,1,5) auf einer durchgehenden Schicht aus niederohmigem Halbleitermaterial (2a) aufgebracht ist.

**9.** Elektronisches Bauelement nach einem der Ansprüche 7 und 8,
**gekennzeichnet durch**
mindestens ein weiteres, sich an das Schichtsystem anschließendes, ebenfalls streifenförmig strukturierte Schichtenpaar (1', 5') aus leitfähigem Material und einer Isolatorschicht, dessen Zwischenräume ebenfalls mit halbleitendem Material ausgefüllt sind.

**10.** Elektronisches Bauelement nach einem der Ansprüche 7 bis 9,
**dadurch gekennzeichnet,**
daß die Dicken der Isolatorschichten (5) größer sind als die Weiten der Raumladungszonen (4), soweit sich diese in Halbleitermaterial oberhalb und unterhalb des Streifengitters ausbilden würden.

FIG. 1a

FIG. 1b

FIG. 2